# EUROPEAN PATENT APPLICATION

(11) **EP 3 499 249 A1**
(43) Date of publication of application: **19.06.2019**
(21) Application number: 18212166.5
(22) Date of filing: 13.12.2018
(51) Int. Cl.: G01R 15/20

(54) **ELECTRONIC COMPONENT**

(30) Priority: 14.12.2017 JP 2017239954
(71) Applicant: AISIN SEIKI KABUSHIKI KAISHA, Kariya-shi, Aichi-ken 448-8650 (JP)
(72) Inventor: MITSUBAYASHI, Noriaki, KARIYA-SHI, AICHI-KEN, 448-8650 (JP); ISHIDA, Hisaki, KARIYA-SHI, AICHI-KEN, 448-8650 (JP); FUJITA, Noriaki, KARIYA-SHI, AICHI-KEN, 448-8650 (JP)
(74) Representative: Cabinet Beau de Loménie

(57) **Abstract**

An electronic component (1) includes: a first package (21) in which an element (35) is enclosed; a lead (23) electrically connected to the element in the first package and having a bent portion (60, 61) that is bent in an outside of the first package; and a substrate (24) including a first notch (41) allowing a first lead portion (51) of the lead that is closer to a first package side than the bent portion to be inserted thereinto.

## Description

### TECHNICAL FIELD

This disclosure relates to electronic components.

### BACKGROUND DISCUSSION

In the related art, as one of electronic components mounted on a substrate (e.g., a plastic substrate), a lead containing electronic component (hereinafter referred to as a "lead component") in which a lead is provided so as to extend from a molded unit containing an element therein has been used. When mounting this type of lead component on a substrate, after the lead is formed to have a desired shape, the lead is mounted on the substrate and is welded to the substrate through a soldering process (e.g., JP2013-024851A (Reference 1), JP2016-031304A (Reference 2), and JP2014-139556A (Reference 3)).

A current sensor described in Reference 1 includes a magnetic body core disposed so as to surround a conductor through which measurement target current flows with a gap therebetween, a magneto-electric conversion element disposed in the gap and having a lead terminal, and a substrate on which, for example, a drive circuit of the magneto-electric conversion element is mounted. The lead terminal of the magneto-electric conversion element is bent at a substantially right angle in plural directions to form element support portions. A tip end of at least one element support portion among the element support portions is also bent at a substantially right angle to the substrate side to form a positioning bent portion. The positioning bent portion is inserted into a lead terminal insertion hole provided in the substrate. In this way, the magneto-electric conversion element is mounted on the substrate.

A current detection device described in Reference 2 includes a substrate disposed in the vicinity of a conductor which generates magnetic flux therearound according to the flow of current and a magnetic detection element having plural leads arranged at a predetermined pitch. The magnetic detection element is bent at two locations so as to allow the tip end side of the lead to be inserted into a lead hole in the substrate and is mounted on the substrate.

A current sensor described in Reference 3 includes a housing which holds a bus bar to which current is applied and a core disposed around the bus bar, a circuit board fixed to the housing in a state of being disposed so as to face the housing, and a detection element for detecting current. The detection element includes an element body held in the housing and plural connection terminals (leads) fixed in a through-hole in the circuit board. The connection terminal (lead) is bent at a substantially right angle in plural directions, and the tip end side thereof is bent at a substantially right angle to the substrate side and is inserted through a surface among opposite surfaces of the circuit board which faces the housing. In this way, the detection element is mounted on the substrate.

The techniques described in the above References 1 to 3 need to perform lead forming through plural processes since the lead is bent at many locations in many directions. Therefore, the manufacturing cost is high.

Thus, a need exists for an electronic component capable of suppressing the manufacturing cost.

### SUMMARY

A feature of an electronic component according to an aspect of this disclosure resides in that the electronic component includes a first package in which an element is enclosed, a lead electrically connected to the element in the first package and having a bent portion that is bent in an outside of the first package, and a substrate including a first notch allowing a first lead portion of the lead that is closer to a first package side than the bent portion to be inserted thereinto.

According to this configuration, it is possible to bend the lead connected to the first package at one location along the same direction. Therefore, it is possible to easily perform lead forming for mounting the first package on the substrate. As a result, it is possible to reduce manufacturing costs of the electronic component.

In addition, since the substrate includes the first notch allowing the first lead portion of the lead which is located closer to the first package side than the bent portion to be inserted therein, it is easy to mount the first package on the substrate. In addition, since the substrate includes the first notch, the substrate does not require a hole having a size by which the first package may be inserted therethrough, and it is possible to reduce the size of the substrate by merely forming the first notch to have a size in which the first lead portion can be inserted into the first notch.

Another feature resides in that the electronic component further includes a second package provided on an end side of the lead different from an end side connected to the first package, and the substrate includes a hole configured to hold the second package therein.

According to this configuration, since the second package is held in the hole in the substrate, it is possible to accurately position the second package with respect to the substrate. Thus, it is possible to improve the accuracy of positioning of the electronic component.

Another aspect resides in that the electronic component further includes a second package provided on an end side of the lead different from an end side connected to the first package, and the substrate includes a second notch allowing the second package to be inserted thereinto and held therein.

According to this configuration, since the second package is held in the second notch in the substrate, it is possible to accurately position the second package with respect to the substrate. Thus, it is possible to improve the accuracy of positioning of the electronic component. In addition, since both the first lead portion and the second package can be introduced from the openings of the notches (the first notch and the second notch) formed in the substrate, it is easy to mount the first package and the second package with respect to the substrate.

Another feature resides in that the lead has a second bent portion that is bent in an outside of the second package at a position that is closer to a second package side than the bent portion, the second notch allows a second lead portion of the lead that is closer to the second package side than the second bent portion to be inserted thereinto, and the second notch has a width that is greater than a thickness of the lead and is less than a thickness of the second package in a direction parallel to a thickness direction of the lead in the second lead portion.

According to this configuration, since the width of the second notch in the substrate may be reduced, it is possible to increase the strength of the substrate and to accurately position the second package. Thus, it is possible to improve the accuracy of positioning of the electronic component.

Another feature resides in that the first notch has a width that is greater than the thickness of the lead and is less than a thickness of the first package in the direction parallel to the thickness direction of the lead in the first lead portion.

According to this configuration, since the width of the first notch in the substrate may be reduced, it is possible to increase the strength of the substrate and to accurately position the first package. Thus, it is possible to improve the accuracy of positioning of the electronic component.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a perspective view of an electronic component according to a first embodiment;
Fig. 2 is a side cross-sectional view of the electronic component according to the first embodiment;
Fig. 3 is an exploded perspective view of the electronic component according to the first embodiment;
Fig. 4 is a perspective view of an electronic component according to a second embodiment;
Fig. 5 is a side cross-sectional view of the electronic component according to the second embodiment;
Fig. 6 is a perspective view of an electronic component according to a third embodiment;
Fig. 7 is a side cross-sectional view of the electronic component according to the third embodiment; and
Fig. 8 is a perspective view of an electronic component according to another embodiment.

### DETAILED DESCRIPTION

Hereinafter, embodiments disclosed here will be described with reference to the drawings.

### [First Embodiment]

An electronic component according to this disclosure is configured in a manner such that a sensor in which an element is enclosed is mounted in a state of being erected with respect to a substrate. In addition, hereinafter, an electronic component including a Hall IC used for a current sensor will be described by way of example.

A Hall IC is a type of magnetic sensor and is configured to detect current (measurement target current) flowing through a conductor. Here, when current flows through the conductor, a magnetic field is generated around the conductor according to the magnitude of the current, and magnetic flux is generated by the magnetic field. A Hall element included in the Hall IC detects the magnetic flux density of such magnetic flux, and the Hall IC detects the current (current value) flowing through the conductor based on the magnetic flux density detected by the Hall element.

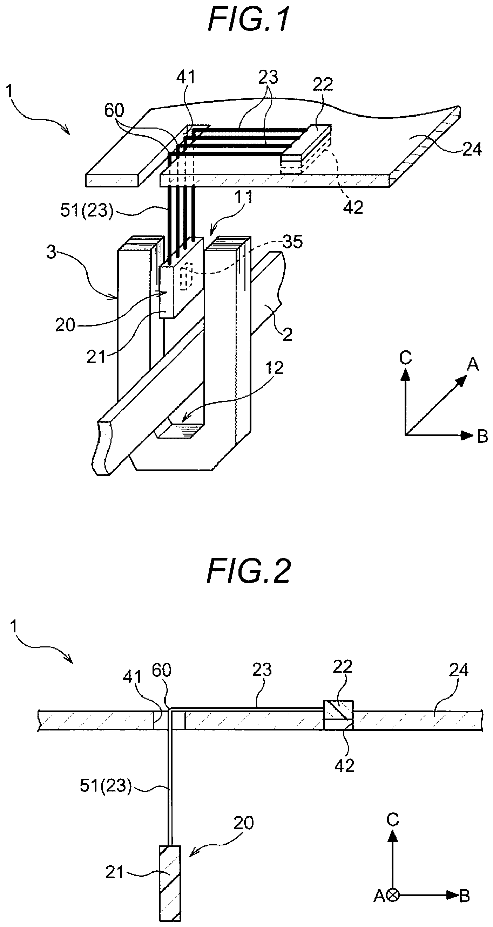

Fig. 1 is a perspective view of an electronic component 1. The electronic component 1 includes a magnetic sensor 20 and a substrate 24. A current sensor includes the electronic component 1 and a magnetic body core (hereinafter referred to as a "core") 3. The current sensor detects current flowing through a conductor 2 which penetrates the core 3. In order to facilitate understanding, a direction in which the conductor 2 through which current flows extends is defined as a direction A, and among directions orthogonal to the direction A, a direction parallel to the surface of the substrate 24 is defined as a direction B and a direction orthogonal to each of the direction A and the direction B is defined as a direction C.

As illustrated in Fig. 1, the conductor 2 is provided so as to penetrate a groove 12 in the core 3. In the present embodiment, the conductor 2 corresponds to a bus bar which electrically interconnects a three-phase rotary electric machine and an inverter which controls the rotation of the three-phase rotary electric machine. In a case of the three-phase rotary electric machine, three bus bars are provided. In this case, the electronic component 1 is provided on each of these three conductors 2. However, only one bus bar is illustrated in Fig. 1.

The core 3 is configured as a magnetic body which has an opening 11 in a portion of a ring shape thereof and is formed with the groove 12. The conductor 2 is inserted through the groove 12 in the core 3. Thus, magnetic flux generated around the conductor 2 is easily collected by the core 3.

The magnetic sensor 20 includes a first package 21, a second package 22, and a lead 23. An element 35 is enclosed in the first package 21. In the present embodiment, the element 35 corresponds to a Hall element that detects the magnetic flux density of magnetic flux generated around the conductor 2 according to the current flowing through the conductor 2. The Hall element detects the magnetic flux density of magnetic flux generated in the opening 11 of the groove 12. The first package 21 is molded using a resin in a state of containing the Hall element therein. The first package 21 is disposed so that a detection surface of the Hall element is orthogonal to the magnetic flux generated in the opening 11 of the groove 12.

The lead 23 is electrically connected to the element 35 in the first package 21 and has a bent portion 60 which is bent outside the first package 21. Plural (four in the present embodiment) leads 23 are provided parallel to each other. As described above, the element 35 (the Hall element in the present embodiment) is enclosed in the first package 21. The lead 23 is formed of a conductor and is electrically connected to a terminal of the element 35. In the present embodiment, the Hall element includes three terminals including a power supply terminal, a ground terminal, and an output terminal. In the example of Fig. 1, three of the four leads 23 are electrically connected to the three terminals, and a remaining one is connected to a non-connection terminal (so-called an NC terminal) which is not electrically connected to the three terminals. The four leads 23 are insert-molded, together with the element 35, into the first package 21 using a resin.

In addition, the lead 23 extends from the first package 21 (in the direction C in the example of Fig. 1) and is bent (to follow the direction B in the example of Fig. 1) outside the first package 21 so as to have a predetermined angle with respect to the direction in which the lead 23 extends from the first package 21. In the present embodiment, there are provided four leads 23, all of which are bent in the same direction.

The second package 22 is provided on the other end side of the lead 23 which is different from one end side to which the first package 21 is connected among both ends of the lead 23. The second package 22 is resin-molded with the lead 23 inserted thereinto, and a portion of the lead 23 is buried in the second package 22. As described above, in the present embodiment, the first package 21 is disposed in the opening 11 in the core 3. The second package 22 is provided separately from the first package 21 outside the groove 12 in the core 3 so as to be spaced apart from the first package 21. The second package 22 is supported by the lead 23 which extends from the first package 21 to the second package 22, and the above-described bent portion 60 is provided between the first package 21 and the second package 22 by bending the lead 23. By providing the second package 22, it is possible to prevent deformation of the lead 23 in an assembly process.

The magnetic sensor 20 is mounted on the substrate 24. The substrate 24 has a first notch 41 cutoff from the end thereof and a hole 42 penetrating the substrate 24 in the thickness direction (corresponding to the direction C in the example of Fig. 1). A first lead portion 51 of the lead 23 which is located closer to the first package 21 side than the bent portion 60 is inserted through the first notch 41. The first lead portion 51 refers to a portion between the first package 21 and the bent portion 60 of the lead 23 which interconnects the first package 21 and the second package 22. In the present embodiment, the first notch 41 has a width by which the first package 21 is inserted through the first notch 41, and is formed so as to penetrate the substrate 24 in the thickness direction (corresponding to the direction C in the example of Fig. 1). As illustrated in Fig. 2, in the present embodiment, the magnetic sensor 20 is mounted on the substrate 24 in a state where the first lead portion 51 of the lead 23 is spaced apart from the inner surface of the first notch 41.

The hole 42 has a size by which, among constituent surfaces of the second package 22, the surface (bottom surface) which faces the substrate 24 in a state where the lead 23 is bent may be inserted into the hole 42, and at least a portion of the second package 22 is inserted into the hole 42. In the present embodiment, the second package 22 is disposed in a state where a portion thereof from the bottom surface thereof to a position at which the lead 23 is provided is buried in the hole 42 (see Fig. 2).

At this time, the size of the hole 42 may be set to be approximately the same as that of the second package 22 so that the second package 22 is fixed to the hole 42 by slight press-fitting. Therefore, it is possible to accurately position the electronic component 1 with respect to the substrate 24.

By configuring the lead 23 and the substrate 24 in this manner, it is possible to bend the lead 23 at one location in a given direction. Therefore, it is possible to easily perform lead forming for mounting the first package 21 on the substrate 24. As a result, it is possible to reduce manufacturing costs of the electronic component 1.

In addition, since the first lead portion 51 of the lead 23 may be introduced from the opening of the first notch 41 in the substrate 24, it is easy to mount the magnetic sensor 20 on the substrate 24. In addition, since the substrate 24 has the first notch 41, the substrate 24 does not require a hole having a size by which the first package 21 may be inserted therethrough, and it is possible to reduce the size of the substrate 24 by merely forming the first notch 41 to have a size by which the first lead portion 51 may be introduced into the first notch 41.

### [Second Embodiment]

The first embodiment has illustrated a configuration of the electronic component 1 in which the substrate 24 has the first notch 41 into which the first lead portion 51 may be introduced and the hole 42 which holds the second package 22. The electronic component 1 of a second embodiment is different from the electronic component 1 of the first embodiment in terms of the shapes of the first notch 41 and the second package 22 of the substrate 24. Hereinafter, the second embodiment will be described about differences from the first embodiment.

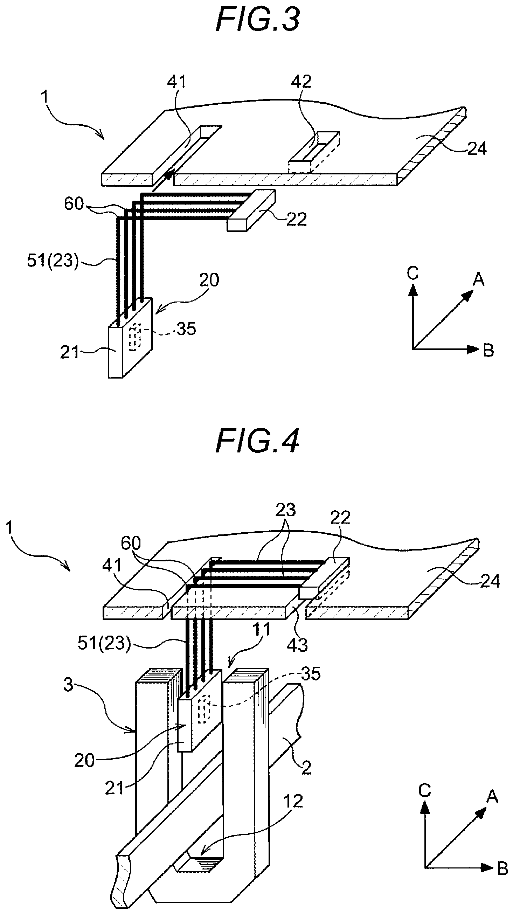

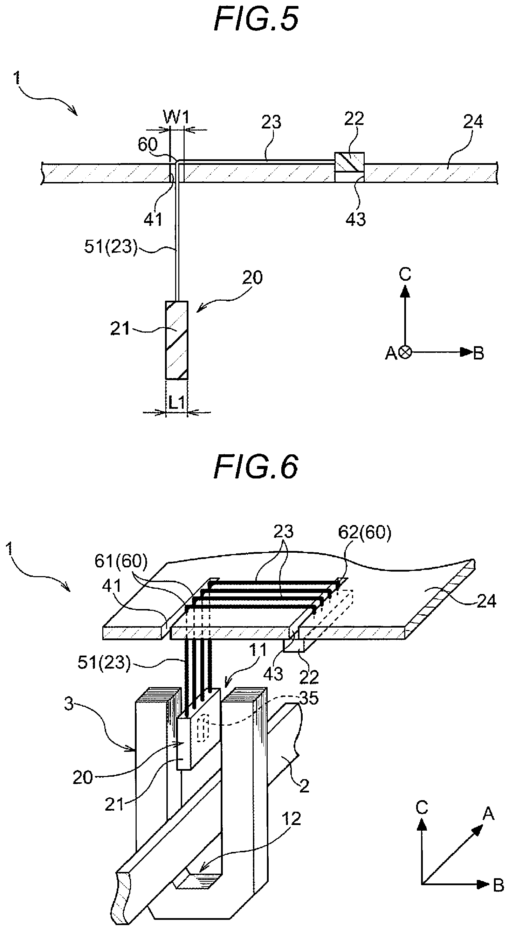

As illustrated in Figs. 4 and 5, in the present embodiment, the width W1 of the first notch 41 in the substrate 24 is greater than the thickness of the lead 23 and is less than the thickness L1 of the first package 21 in a direction parallel to the thickness direction of the lead 23 in the first lead portion 51. With such a configuration, since the width W1 of the first notch 41 in the substrate 24 may be reduced, it is possible to increase the strength of the substrate 24 and to accurately position the first package 21. Thus, it is possible to improve the accuracy of positioning of the electronic component 1.

In addition, the substrate 24 has a second notch 43 into which the second package 22 may be introduced and held. The second notch 43 has a width by which the second package 22 may be inserted into the second notch 43, and is formed so as to penetrate the substrate 24 in the thickness direction (corresponding to the direction C in the example of Fig. 1). With such a configuration, since the second package 22 is held in the second notch 43 in the substrate 24, it is possible to accurately position the second package 22 with respect to the substrate 24. Thus, it is possible to improve the accuracy of positioning of the electronic component 1. In addition, since both the first lead portion 51 and the second package 22 may be introduced from the openings of the notches (the first notch 41 and the second notch 43) formed in the substrate 24, it is easy to mount the magnetic sensor 20 on the substrate 24.

### [Third Embodiment]

The electronic component 1 according to the second embodiment has been described above as being configured such that the lead 23 has the bent portion 60 and to have an "L"-shaped form when viewed from the lateral side as illustrated in Fig. 5. The electronic component 1 of the present embodiment is different from the electronic component 1 of the above embodiment in that the lead 23 has plural bent portions 61 and 62. Hereinafter, a third embodiment will be described about differences from the second embodiment.

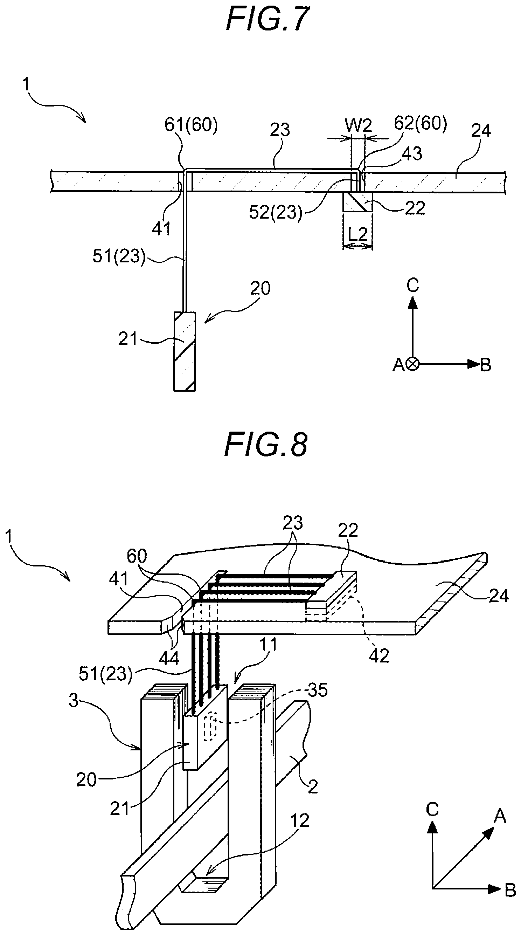

As illustrated in Figs. 6 and 7, when the bent portion formed at a location corresponding to the bent portion 60 in the second embodiment is the first bent portion 61, in the present embodiment, the lead 23 further has a second bent portion 62 which is bent between the first bent portion 61 and the second package 22. The first bent portion 61 and the second bent portion 62 are an example of the bent portion. The second bent portion 62 is bent with respect to the direction in which the lead 23 extends so as to extend along the thickness direction of the substrate 24 (the direction C in the example of Fig. 6) similarly to the first bent portion 61. Thus, when viewing the lead 23 of the magnetic sensor 20 from the lateral side of the substrate 24, as illustrated in Fig. 7, the lead 23 is formed to have a "U"-shaped form.

A second lead portion 52 of the lead 23 which is closer to the second package 22 side than the second bent portion 62 may be introduced into the second notch 43 in the substrate 24. In addition, the width W2 of the second notch 43 is greater than the thickness of the lead 23 and is less than the thickness L2 of the second package 22 in a direction parallel to the thickness direction of the lead 23 in the second lead portion 52.

Thus, the second package 22 may be held in a state of protruding to the back side of the substrate 24. In addition, by reducing the width W2 of the second notch 43 in the substrate 24, it is possible to increase the strength of the substrate 24 and to accurately position the second package 22. As a result, it is possible to improve the accuracy of positioning of the electronic component 1.

### [Other Embodiments]

In the above embodiment, an example in which the first notch 41 formed in the substrate 24 is configured with a straight groove has been described, but, as illustrated in Fig. 8, the first notch 41 may have a tapered portion 44 which is gradually increased in width toward the open end of the substrate 24. When the first notch 41 is provided with the tapered portion 44, it is easy to introduce the lead 23 into the first notch 41. Although not illustrated, when the second notch 43 is provided in the substrate 24, the second notch 43 may have a tapered portion which is gradually increased in width toward the open end of the substrate 24.

In the above embodiment, the element 35 has been described as being a Hall element, but the element 35 may be an element having other functions. Thus, the electronic component 1 may be a component having a function different from that of the Hall IC.

In the first embodiment and the second embodiment, the second package 22 has been described as being fixed to the hole 42 or the second notch 43, but the second package 22 may not be fixed to the hole 42 or the second notch 43, and the hole 42 or the second notch 43 may be sufficiently larger than the second package 22.

In the above embodiment, the first lead portion 51 has been described as being spaced apart from the inner surface of the first notch 41, but the first lead portion 51 may be provided in contact with the inner surface of the first notch 41. In addition, the first lead portion 51 may be provided in contact with the inner surface of the bottom side (depth side) of the groove of the first notch 41.

In the above embodiment, the number of leads 23 has been described as being four including an unused lead that is not used, but the number of leads 23 may be five or more, or may be three or less. In addition, the plural leads 23 may lack an unused lead. In this case, the plural leads may be configured so as not to be connected to each other via solders.

This disclosure is available for electronic components.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

## Claims

1. An electronic component (1) comprising:
a first package (21) in which an element (35) is enclosed;
a lead (23) electrically connected to the element (35) in the first package (21) and having a bent portion (60, 61) that is bent in an outside of the first package (21); and
a substrate (24) including a first notch (41) allowing a first lead portion (51) of the lead (23) that is closer to a first package (21) side than the bent portion (60, 61) to be inserted thereinto.

2. The electronic component (1) according to claim 1, further comprising a second package (22) provided on an end side of the lead (23) different from an end side connected to the first package (21),
wherein the substrate (24) includes a hole (42) configured to hold the second package (22) therein.

3. The electronic component (1) according to claim 1, further comprising a second package (22) provided on an end side of the lead (23) different from an end side connected to the first package (21),
wherein the substrate (24) includes a second notch (43) allowing the second package (22) to be inserted thereinto and held therein.

4. The electronic component (1) according to claim 3,
wherein the lead (23) has a second bent portion (60, 62) that is bent in an outside of the second package (22) at a position that is closer to a second package (22) side than the bent portion (60, 61),
the second notch (43) allows a second lead portion (52) of the lead (23) that is closer to the second package (22) side than the second bent portion (60, 62) to be inserted thereinto, and
the second notch (43) has a width (W2) that is greater than a thickness of the lead (23) and is less than a thickness (L2) of the second package (22) in a direction parallel to a thickness direction of the lead (23) in the second lead portion (52).

5. The electronic component (1) according to any one of claims 1 to 4,
wherein the first notch (41) has a width (W1) that is greater than the thickness of the lead (23) and is less than a thickness (L1) of the first package (21) in the direction parallel to the thickness direction of the lead (23) in the first lead portion (51).
